**Europäisches Patentamt**

**European Patent Office**

**Office européen des brevets**

(19)

(11) Veröffentlichungsnummer: **0 169 453**

**A1**

(12) # EUROPÄISCHE PATENTANMELDUNG

(21) Anmeldenummer: **85108684.3**

(22) Anmeldetag: **11.07.85**

(51) Int. Cl.⁴: **H 01 J 37/24**
**H 04 N 3/20**

(30) Priorität: **25.07.84 DE 3427455**

(43) Veröffentlichungstag der Anmeldung:
**29.01.86 Patentblatt 86/5**

(84) Benannte Vertragsstaaten:
**DE FR GB NL**

(71) Anmelder: **Siemens Aktiengesellschaft**
**Berlin und München Wittelsbacherplatz 2**
**D-8000 München 2(DE)**

(72) Erfinder: **Brust, Hans-Detlef**
**Martin-Luther-Strasse 2**
**D-6602 Dudweiler(DE)**

(72) Erfinder: **Otto, Johann, Dipl.-Ing. (FH)**
**Pater-Hammerschmid-Strasse 4**
**D-8170 Bad Tölz(DE)**

(54) **Schaltungsanordnung zur Vermeidung von Einbrennerscheinungen auf dem Bildschirm eines Sichtgerätes.**

(57) Schaltung zur Vermeidung von Einbrennerscheinungen auf dem Bildschirm (23) eines Sichtgerätes (2, 3) mit einem intensitätsgesteuerten und über Ablenksysteme (21, 22) positionsgesteuerten Elektronenstrahl (19), insbesondere für ein Raster-Elektronenmikroskop (1). Der hierbei angestrebte sichere Einbrennschutz wird durch eine Ausbildung der Schaltung erreicht, bei der Signaleingang (24) wenigstens eines Ablenksystems (21) mit einem Differenzierglied beschaltet ist, dessen Ausgang mit dem ersten Eingang eines mit einer Referenzspannung belegten Komparators verbunden ist, wobei der Komparatorausgang an den Eingang eines nachtriggerbaren monostabilen Kippgliedes geschaltet ist, das die Intensitätssteuerung des Elektronenstrahls (19) beeinflußt.

FIG 1

0169453

Siemens Aktiengesellschaft          Unser Zeichen
Berlin und München                  VPA  84 P 1537 E


Schaltungsanordnung zur Vermeidung von Einbrennerscheinungen auf dem Bildschirm eines Sichtgerätes


Die Erfindung bezieht sich auf eine Schaltungsanordnung
zur Vermeidung von Einbrennerscheinungen auf dem Bildschirm eines Sichtgerätes nach dem Oberbegriff des Patentanspruchs 1.


Eine bekannte Schaltungsanordnung dieser Art ist beim
Raster-Elektronenmikroskop Cambridge Stereoscan S 150
vorgesehen. Wird der Elektronenstrahl bei diesem Gerät
z.B. mittels einer externen Ansteuerung der Ablenksysteme positioniert (Spot-Betrieb), so bewirkt diese Schaltung eine zusätzliche Ablenkung des Elektronenstrahls im
Sichtgerät längs eines kleinen Kreises. Hierdurch wird
vermieden, daß ein über einen längeren Zeitraum angesteuerter Bildpunkt durch eine zu hohe Energiedosis
zerstört oder beschädigt wird. Die Intensitätssteuerung
des Elektronenstrahls durch eine von der Mikroskopsäule
erhaltene Helligkeitsinformation wird in diesem Betrieb
aufgehoben und durch eine Einstellung des Sichtgerätes
auf eine konstante Helligkeit des jeweils beschriebenen
Kreises ersetzt. Damit ist aber die bildliche Darstellung eines mit dem Raster-Elektronenmikroskop zu untersuchenden Präparates auf dem Bildschirm im Spot-Betrieb
nicht möglich.


Der Erfindung liegt die Aufgabe zugrunde, eine einfach
aufgebaute Schaltungsanordnung der eingangs genannten
Art anzugeben, die einen Betrieb des Sichtgeräts mit
langsamer Strahlablenkung und demzufolge großer Verweilzeit des Elektronenstrahls bezüglich einzelner St 1 Sti/26.6.1984 Bildpunkte ermöglicht, ohne die Intensitätssteuerung des Elektronenstrahls im Sichtgerät in Abhängigkeit von einer zugeführten Helligkeitsinformation zu unterbinden. Das wird erfindungsgemäß durch eine Ausbildung der Schaltung nach dem kennzeichnenden Teil des Patentanspruchs 1 erreicht.

Der mit der Erfindung erzielbare Vorteil liegt insbesondere darin, daß langsame Ablenkgeschwindigkeiten bzw. große Verweilzeiten des Elektronenstrahls im Sichtgerät, wie sie z.B. bei der rechnergesteuerten Wiedergabe eines mittels eines Raster-Elektronenmikroskops gewonnenen und elektronisch gespeicherten Präparatbildes auftreten, keine Einbrennflecken auf der Leuchtschicht der Bildröhre verursachen können.

Die Ansprüche 2 bis 14 sind auf bevorzugte Ausgestaltungen und Weiterbildungen der Erfindung gerichtet.

Die Erfindung wird nachfolgend anhand der Zeichnung näher erläutert. Dabei zeigt:

Fig. 1 das Prinzipschaltbild eines Raster-Elektronenmikroskops mit einer erfindungsgemäßen Schaltung,

Fig. 2 eine grundsätzliche Ausführungsform der erfindungsgemäßen Schaltung und

Fig. 3 eine Weiterbildung der Schaltung nach Fig. 2.

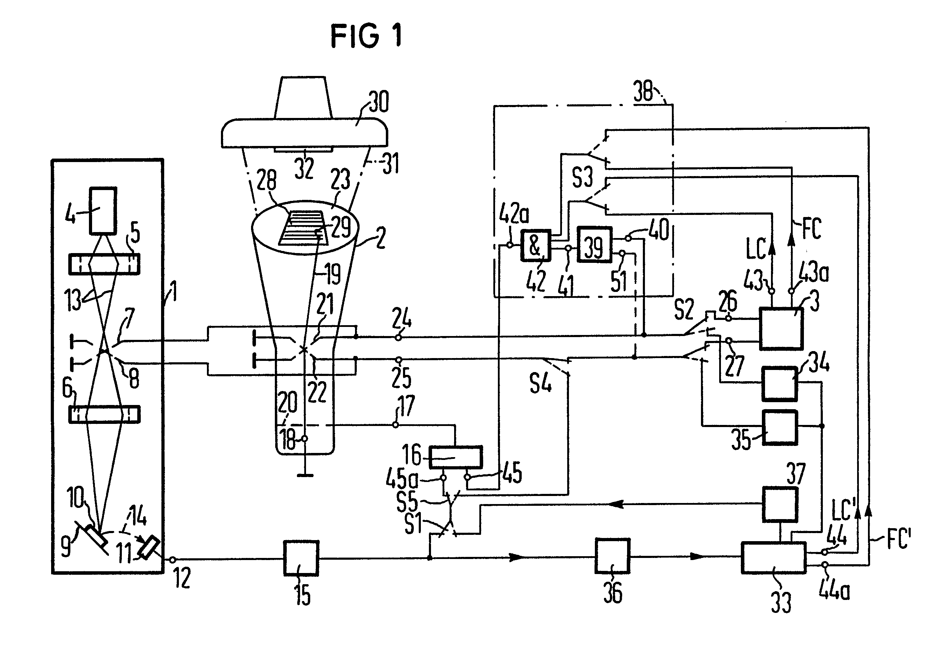

Das in Fig. 1 dargestellte Raster-Elektronenmikroskop besteht aus einer Mikroskopsäule 1 und einer Bildröhre 2, die zusammen mit einem Rastergenerator 3 im wesentlichen das zugehörige Sichtgerät bildet. Die Mikroskopsäule 1 enthält einen Elektronenkanone 4, zwei als magnetische Linsen wirkende Fokussierspulen 5, 6, zwei magnetische Ablenksysteme 7, 8, einen Probenhalter 9, eine auf diesem befestigte Probe 10 und einen Detektor 11, dessen Ausgang mit 12 bezeichnet ist. Die Elektronenkanone 4 weist dabei eine Kathode, einen Wehneltzylinder und eine Anode auf, wie beispielsweise dem Buch "Raster-Elektronenmikroskopie" von L. Reimer und G. Pfefferkorn, Springer-Verlag Berlin 1973, Seiten 1 bis 3, insbesondere Abbildung 1.1, entnommen werden kann. Ein mittels 4 erzeugter und durch die Spulen 5 und 6 fokussierter Elektronenstrahl 13 wird mittels der Ablenksysteme 7, 8 so beeinflußt, daß er die Probe 10 in einem Zeilenraster überstreicht. Während seiner Ausrichtung auf einen bestimmten Punkt der Probenoberfläche rufen die dort auftreffenden Elektronen eine Emission von Sekundärelektronen 14 hervor, die durch ein elektrisches Feld dem Detektor 11 zugeführt werden und am Ausgang 12 ein entsprechendes Signal ergeben. Andererseits kann der Ausgang 12 auch so beschaffen sein, daß an ihm ein beliebiges anderes Nutzsignal abgegriffen wird, das in 1 entsteht, beispielsweise mittels rückgesteuerter Elektroden oder mittels eines Probenstromes (vgl. obige Literaturstelle).

Das am Ausgang 12 auftretende Signal wird über einen Signalverstärker 15, Umschalter S1 und S5 und eine Kontrolleinheit 16 dem Intensitätssteuereingang 17 der Bildröhre 2 zugeführt. Diese enthält eine Kathode 18, eine z.B. als Wehneltzylinder ausgebildete Intensitätssteuerelektrode 20, die mit dem Steuereingang 17 verbunden ist, zwei den Elektronenstrahl 19 beeinflussende Ablenksysteme 21, 22 und einen Bildschirm 23. Die einander parallel geschalteten Ablenksysteme 7 und 21, die jeweils eine Ablenkung von 13 und 19 in x-Richtung bewirken, sind mit einem gemeinsamen Anschluß 24 verbunden, während die einander parallel geschalteten Ablenksysteme 8 und 22, die jeweils eine Ablenkung von 13 und 19 in y-Richtung vornehmen, an einen gemeinsamen Anschluß 25 geführt sind. Alle vorstehend genannten Ablenksysteme sind einpolig auf Bezugspotential geschaltet.

Wenn der Rastergenerator 3 über seinen Ausgang 26 und einen Umschalter S2 dem Anschluß 24 eine zeilenfrequente sägezahnförmige Ablenkspannung und über seinen Ausgang 27 und S2 sowie einem weiteren Umschalter S dem Anschluß 25 eine bildfrequente sägezahnförmige Ablenkspannung zuführt, wobei die Bildfrequenz um einen der Zeilenanzahl entsprechenden Faktor kleiner ist als die Zeilenfrequenz, so werden die Probenoberfläche von dem Elektronenstrahl 13 und synchron dazu eine Fläche 28 auf dem Bildschirm 23 von dem Elektronenstrahl 19 rasterartig überstrichen. Da von jedem einzelnen Punkt der Probenoberfläche ein für diesen charakteristisches Signal am Ausgang 12 erscheint, das über den Eingang 17 eine Intensitätssteuerung des Elektronenstrahls 19 bewirkt, erhält der dem betrachteten Punkt auf der diesem Punkt jeweils zugeordnete Bildpunkt, z.B. 29, auf dem Bildschirm 23 eine entsprechende Helligkeit. Dabei entsteht ein Bild der Probenoberfläche innerhalb der Fläche 28 auf dem Bildschirm 23. Dieses Bild kann durch eine mit 28 angedeutete fotografische Kamera 30 aufgenommen werden, wobei zweckmäßigerweise zur Ausschaltung von Fremdlichteinflüssen ein Schirm 31 zwischen dem Bildschirm 23 und der Kameraoptik 32 angeordnet ist.

Die von der Probenoberfläche abgeleiteten, am Detektorausgang 12 abgreifbaren Signale können auch elektronisch gespeichert werden. Hierbei übernimmt ein Rechner 33 in der gestrichelten Stellung des Umschalters S2 anstelle des Rastergenerators 3 die sequentielle Ansteuerung der einzelnen Punkte auf der Oberfläche der Probe 10 und der entsprechenden Punkte auf dem Bildschirm 23. Über das Leitwerk des Rechners 33 werden nacheinander einzelne Gruppen von Speicherplätzen adressiert, die jeweils aus drei Teilgruppen bestehen. Bei der Adressierung einer solchen Gruppe wird aus ihrer ersten Teilgruppe ein erstes digitales Positionssignal an einen Digital-Analog-Konverter 34 ausgegeben, der dieses in eine erste Ablenkspannung umformt, die über S2 dem Anschluß 24 zugeführt wird und die Elektronenstrahlen 13 und 19 auf eine erste Koordinate in der x-Ablenkrichtung einstellt. Gleichzeitig wird aus der zweiten Teilgruppe ein zweites digitales Positionssignal an einen Digital-Analog-Konverter 35 ausgegeben, der dieses in eine zweite Ablenkspannung umformt, die über S2 und S4 dem Anschluß 25 mitgeteilt wird, wobei die Elektronenstrahlen 13 und 19 auf eine zweite Koordinate in y-Ablenkrichtung eingestellt werden. Von dem in dieser Weise aufgesuchten Punkt der Probenoberfläche wird in der beschriebenen Weise ein an 12 auftretendes Signal erhalten, das über den Signalverstärker 15 und einen Analog-Digital-Konverter 36 dem Rechner 33 als eine Helligkeitsinformation zugeführt und in der dritten Teilgruppe der betrachteten Speicherplatzgruppe abgespeichert wird. Dieser Vorgang wiederholt sich für jeden interessierenden Punkt der Probenoberfläche. Insbesondere wird letztere dabei in einem zeilenförmigen Raster überstrichen, wobei das Bild der Probenoberfläche in einer Anzahl von Speicherplatzgruppen abgespeichert wird, die der Anzahl der Bildpunkte entspricht. In der ausgezogenen Stellung des Umschalters S1 wird das in dieser Weise elektronisch gespeicherte Bild gleichzeitig auf dem Bildschirm 23 dargestellt.

Zur Wiedergabe eines in 33 elektronisch gespeicherten Bildes der Probenoberfläche auf dem Bildschirm 23 wird der Umschalter S1 in seine gestrichelte Lage gebracht,

**0169453**
84 P 1 5 3 7 E

während S2 in der gestrichelten Lage verbleibt. Bei einer sequentiellen Adressierung der den einzelnen Bildpunkten zugeordneten Gruppen von Speicherplätzen in der Reihenfolge des Zeilenrasters wird dann für jeden durch die Positionssignale der jeweils ersten beiden Teilgruppen eingestellten Bildpunkt 29 die in der dritten Teilgruppe gespeicherte digitale Helligkeitsinformation ausgegeben, im Digital-Analog-Konverter 37 in ein analoges Helligkeitssignal umgeformt und über S1 und die Kontrolleinheit 16 dem Intensitätssteuereingang 17 zugeführt. Das elektronisch gespeicherte Bild wird auf diese Weise über den Bildschirm 23 ausgegeben. Der Elektronenstrahl 13 ist dabei mit Vorteil abgeschaltet.

Sowohl bei der mittels des Rechners 33 vorgenommenen als auch bei der über den Rastergenerator 3 veranlaßten Positionssteuerung des Elektronenstrahls 19 kann dieser so lange auf einen Bildpunkt 29 ausgerichtet sein, daß die betreffende Stelle der Leuchtschrift des Bildschirms durch Aufnahme einer zu hohen Energiedosis zerstört oder beschädigt wird. Zur Vermeidung dieses Nachteils ist eine Schaltungsanordnung 38 vorgesehen, die eine als Block dargestellte Teilschaltung 39 mit einem ersten Eingang 40 und einem Ausgang 41 aufweist. Der Eingang 40 ist mit dem Anschluß 24 verbunden, während 41 an den ersten Eingang einer nachgeordneten Logikschaltung 42 geführt ist, die in Figur 1 als ein UND-Gatter realisiert ist. Ein zweiter Eingang von 42 ist über einen Umschalter S3 wahlweise mit einem Ausgang 43 des Rastergenerators 3 und mit einem Ausgang 44 des Rechners 33 verbunden, während ein dritter Eingang von 42 über S3 wahlweise mit einem Ausgang 43a von 3 und einem Ausgang 44a von 33 verbunden ist. Der Ausgang der Logikschaltung 42 ist an einen Steuereingang 45 der Kontrolleinheit 16 geführt.

0169453
84 P 1 5 3 7 E

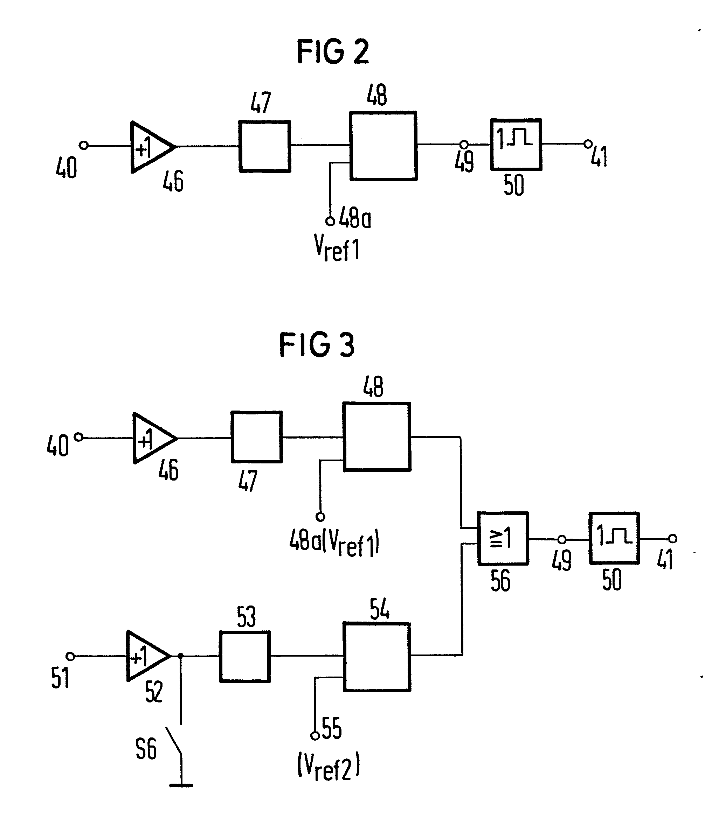

Fig. 2 zeigt die Teilschaltung 39 im Detail. Der Eingang 40 ist über eine Verstärkerstufe mit niedrigem Ausgangswiderstand (Spannungsfolger) mit dem Eingang eines Differenziergliedes 47 beschaltet, dessen Ausgang mit dem ersten Eingang eines Komparators 48 verbunden ist.

Der zweite Eingang 48a desselben ist mit einer Referenzspannung $V_{ref1}$ belegt. Der Ausgang von 48 ist an den Eingang 49 eines nachtriggerbaren monostabilen Kippgliedes 50 geschaltet, dessen Ausgang den Ausgang 41 der Teilschaltung 39 darstellt.

In der oberen (ausgezogenen) Schaltstellung von S2 wird eine vom Rastergenerator 3 erzeugte zeilenfrequente sägezahnförmige Ablenkspannung, die am Anschluß 24 auftritt, über den Eingang 40 dem Differenzierglied 47 zugeführt und in diesem differenziert. Der Ausgangspegel von 47 wird am Komparator 48 mit $V_{ref1}$ verglichen. Übersteigt er $V_{ref1}$, so entsteht in 48 ein Triggersignal, das das monostabile Kippglied 50 triggert, wenn es im stabilen Zustand ist, bzw. nachtriggert, wenn es sich im nichtstabilen Zustand befindet. Wird das Kippglied 50 getriggert, so gibt es ein Kontrollsignal ab, das nach einer für das Kippglied 50 charakteristischen und insbesondere einstellbaren Zeitspanne durch das Rückkippen wieder abgeschaltet wird. Befindet sich 50 während des Auftretens eines Triggersignals im nichtstabilen Zustand, so wird dieser nach dem Auftreten des Triggersignals für die Dauer einer solchen Zeitspanne weiter aufrechterhalten. Erst danach wird das Kontrollsignal des Kippgliedes 50 abgeschaltet.

Im Falle einer Positionssteuerung der Elektronenstrahlen 19 und gegebenenfalls 13 durch den Rastergenerator 3 befindet sich S3 in der ausgezogenen Schaltstellung. Am Ausgang 43 ist ein Signal LC abgreifbar, solange die

0169453

Amplitude der x-Ablenkspannung einen vorgegebenen Wert nicht übersteigt, der der x-Ablenkung für den letzten Bildpunkt jeder Zeile, d.h. dem Zeilenende, entspricht. Wird dieser Wert überschritten, so wird das Signal LC abgeschaltet. Weiterhin wird von 3 über den Ausgang 43a ein Signal FC abgegeben, so lange die Amplitude der über 27 abgegebenen y-Ablenkspannung einen vorgegebenen Wert nicht übersteigt, der der y-Ablenkung für die unterste Zeile des Rasters, d.h. dem unteren Bildrand, entspricht. Tritt der Elektronenstrahl 19 über den unteren Bildrand hinaus, so wird FC abgeschaltet.

Wird nun der Elektronenstrahl 19 in x-Ablenkrichtung schneller über den Bildschirm bewegt als es einer durch $V_{ref1}$ vorgegebenen minimalen Ablenkgeschwindigkeit entspricht, so liefert der Komparator 48 ein kontinuierliches Triggersignal für das Kippglied 50, wodurch dieses ständig im nichtstabilen Zustand gehalten wird und am Ausgang 41 ein Kontrollsignal abgibt, das bei gleichzeitigem Auftreten von LC und FC auf den Ausgang 42a der Logikschaltung 42 übertragen wird. Dieses Kontrollsignal beeinflußt die Kontrolleinheit 16 über ihren Steuereingang 45 so, daß ein am Eingang 45a anliegendes Signal auf den Intensitätssteuereingang 17 durchgeschaltet wird. Wird andererseits die minimale Ablenkgeschwindigkeit des Elektronenstrahls 19 unterschritten, so wird das Kontrollsignal am Punkt 41 und damit auch am Steuereingang 45 abgeschaltet und die Durchschaltung eines am Eingang 45a anliegenden Signals auf den Eingang 17 der Bildröhre in der Kontrolleinheit 16 unterbrochen. Der Betrag von $V_{ref1}$ und damit die minimale Ablenkgeschwindigkeit wird so niedrig gewählt, daß für jeden der vom Elektronenstrahl 19 überstrichenen Bildpunkte die aufgenommene Energie einen zulässigen Wert noch nicht überschreitet. Andererseits wird $V_{ref1}$ so groß gewählt, daß auf den Eingang 40 eingekoppelte Störspannungen nicht zu einem Triggersignal am Ausgang des Komparators 48 führen und damit eine Strahlablenkung vortäuschen, die tatsächlich nicht gegeben ist. Sobald der Elektronenstrahl 19 über das Ende einer Zeile hinaustritt, wird LC am Ausgang 43 abgeschaltet, was zur Folge hat, daß das Kontrollsignal am Punkt 42a verschwindet, so daß die Kontrolleinheit 16 den Signalpfad zwischen 45a und 17 unterbricht (unsichtbarer Zeilenrücksprung des Elektronenstrahls). Wenn der Elektronenstrahl 19 andererseits über den unteren Bildrand hinaustritt, wird FC am Ausgang 43 abgeschaltet, was ebenfalls dazu führt, daß ein über 42 abgegebenes Kontrollsignal abgeschaltet und der genannte Signalpfad unterbrochen wird (unsichtbarer Rücksprung des Elektronenstrahls am Bildende).

Die vorstehend beschriebene Wirkungsweise der Schaltungsanordnung 38 gilt auch für den Fall, daß der Rastergenerator 3 anstelle der sägezahnförmigen Ablenkspannungen solche mit treppenförmigem Verlauf abgibt. Ablenkspannungen dieser Art werden beispielsweise auf digitalem Wege mittels eines getakteten Zählers erzeugt, dem ein Tiefpaßfilter nachgeschaltet ist. Hier bewirken die Spannungssprünge zwischen den einzelnen Treppenstufen eine Folge von Triggersignalen am Ausgang des Komparators 48, die zu einer ständigen Nachtriggerung des Kippgliedes 50 führen, was dem oben erwähnten kontinuierlichen Triggersignal entspricht.

Auch im Falle einer Positionssteuerung der Elektronenstrahlen 19 und gegebenenfalls 13 mittels des Rechners 33, d.h. in der gestrichelten Stellung der Umschalter S2 und S3, arbeitet die Schaltungsanordnung 38 wie oben beschrieben. Von den Analog-Digital-Konvertern 34 und 35 abgegebene Ablenkspannungen zeigen hierbei insbesondere einen treppenförmigen Verlauf, falls die Fläche 28 und die Probenoberfläche mit einem Zeilenraster überstrichen werden. Die Signale LC und FC werden durch gleichartige, an den Ausgängen 44 und 44a des Rechners 33 abgreifbare Signale LC' und FC' ersetzt. Dabei wird LC' so lange über den Ausgang 44 abgegeben, als der Elektronenstrahl 19 nicht über den letzten Bildpunkt einer jeden Zeile hinaustritt, während FC' so lange abgegeben wird, als der Elektronenstrahl 19 nicht über den unteren Bildrand hinaustritt. Beim Überschreiten des Zeilenendes bzw. des Bildrandes werden LC' bzw. FC' abgeschaltet, was jeweils dazu führt, daß die logische Schaltung 42 ein am Ausgang 41 etwa vorhandenes Kontrollsignal unterbricht, so daß der Eingang 45 von einem sonst vorhandenen Kontrollsignal freigeschaltet wird, und der Signalpfad zwischen 45a und 17 in der Kontrolleinheit 16 unterbrochen wird (Dunkeltastung des Elektronenstrahls 19). Aber auch im Spot-Betrieb, in dem eine Folge von einzelnen isolierten Bildpunkten 29 angesteuert wird, bewirken die Spannungssprünge beim Umschalten auf den jeweils folgenden Bildpunkt eine Triggerung des Kippgliedes 50. Bei einer zu großen Verweildauer des Elektronenstrahls 19 auf einem bestimmten Bildpunkt wird dann der Signalpfad in der Kontrolleinheit 16 in der bereits beschriebenen Weise unterbrochen, um Einbrennerscheinungen auf der Leuchtschicht des Bildschirms 23 zu vermeiden.

Fig. 3 zeigt eine andere Ausführungsform der Teilschaltung 39, die von der Schaltung nach Fig. 2 ausgeht und diese so erweitert, daß auch die y-Ablenkspannungen zur Triggerung des Kippgliedes 50 beitragen. Einzelne Schaltungsteile, die bereits erläutert wurden, tragen dabei die gleichen Bezugszeichen wie in Fig. 2. Zusätzlich ist ein zweiter mit dem Anschluß 25 verbundener Eingang 51 vorgesehen, der über einen Verstärker mit niedrigem Ausgangswiderstand (Spannungsfolger) 52 an ein Differenzierglied 53 gelegt ist, dessen Ausgang mit dem

0169453

ersten Eingang eines Komparators 54 beschaltet ist.
Einem zweiten Eingang 55 des letzteren wird eine Vergleichsspannung $V_{ref2}$ zugeführt. Die Ausgänge der Komparatoren 48 und 54 sind an die Eingänge eines ODER-Gliedes 56 geschaltet, dessen Ausgang mit dem Eingang 49 des
nachtriggerbaren, monostabilen Kippgliedes 50 verbunden
ist. Eine im einzelnen nach den Figuren 1 und 3 ausgebildete Schaltungsanordnung 38 bewirkt nicht nur dann
eine Triggerung des Kippgliedes 50, wenn die am Anschluß
24 anliegende x-Ablenkspannung einen Spannungssprung
aufweist oder eine hinreichend schnelle Änderung erfährt, sondern auch, wenn dies bei der am Anschluß 25
anliegenden y-Ablenkspannung der Fall ist. Hierzu ist es
erforderlich, daß das die y-Ablenkspannung differenzierende Glied 53 einen Signalpegel an den ersten Eingang
des Komparators 54 abgibt, der größer ist als $V_{ref2}$.
Immer dann, wenn einer der Ausgänge von 48 und 54 ein
Triggersignal abgibt, erfolgt eine Triggerung bzw. Nachtriggerung des Kippgliedes 50. Durch die Weiterbildung
wird auch dann, wenn der Elektronenstrahl 19 nur in vertikaler Richtung, jedoch mit hinreichender Geschwindigkeit über den Bildschirm 23 abgelenkt wird, eine Dunkeltastung vermieden. Zweckmäßigerweise wird $V_{ref2}$ so klein
gewählt, daß sich für einen $V_{ref2}$ gerade übersteigenden
Signalpegel eine noch zu tolerierende minimale Ablenkgeschwindigkeit in y-Richtung ergibt, bei der Einbrennerscheinungen sicher vermieden werden, während $V_{ref2}$
andererseits hinreichend groß bemessen werden muß, um
bei Störspannungen, die über den Eingang 51 eingekoppelt
werden, keine Bewegung des Elektronenstrahls vorzutäuschen, die tatsächlich nicht stattfindet.

Bisher wurde davon ausgegangen, daß sich die in Fig. 1
dargestellten Schalter S4 und S5 stets in ihren ausgezogenen Schaltstellungen befinden. Schaltet man nun S4
und S5 in ihre gestrichelt gezeichneten Lagen um, so ergibt sich eine als "slow-scan" bezeichnete Betriebsart, bei der der Elektronenstrahl 19 mittels der an 24 anliegenden, je nach der Stellung von S2 von 3 oder 33 gelieferten x-Ablenkspannung auf dem Bildschirm 23 längs einer Zeile abgelenkt wird. Zusätzlich wird 19 mittels eines je nach der Stellung von S1 über 15 oder 37 gelieferten Signals in y-Richtung derart abgelenkt, daß die Größe seiner vertikalen Abweichung von der beschriebenen Zeile ein Maß für das über 15 oder 37 gelieferte Signal darstellt. Auf diese Weise läßt sich der Amplitudenverlauf eines solchen Signals in Form einer Kurve auf dem Bildschirm 23 darstellen, wie das beispielsweise bei einem Elektronenstrahloszillografen der Fall wäre. Dem Eingang 45a von 16 wird dabei eine in Fig. 1 nicht dargestellte konstante Spannung zugeführt, die eine konstante Helltastung des Elektronenstrahls 19 bewirkt. In dieser Betriebsart muß entweder die Teilschaltung 39 entsprechend Fig. 2 ausgebildet sein oder bei einer Ausbildung nach Fig. 3 eine Unwirksamschaltung des Schaltungszweiges 52, 53, 54 erfolgen, was zweckmäßigerweise durch das Schließen eines Schalters S6 erfolgt, der den Eingang des Differenziergliedes 53 auf Bezugspotential legt.

Unter Weglassung der Teile 1 und 4 bis 15 zeigt Fig. 1 ein allgemein verwendbares Sichtgerät, das mit einer erfindungsgemäßen Schaltungsanordnung 38 ausgerüstet ist. Werden die Umschalter S4 und S5 durch feste Verbindungen erstezt, die ihren ausgezogenen Schaltstellungen entsprechen, so kann man dem Eingang 45a ein die Intensität des Elektronenstrahls 19 steuerndes Signal zuführen, wobei dieser den Bildschirm 23 in Form eines Zeilenrasters überstreicht. Das steuernde Signal kann dabei in der ausgezogenen Stellung von S1 extern zugeführt werden oder in der gestrichelten Stellung von S1 dem Speicher des Rechners 33 entnommen werden. Eine andere Version

**0169453**

eines solchen allgemein verwendbaren Sichtgerätes wird anhand von Fig. 1 unter Weglassung der Teile 1 und 4 bis 15 dadurch veranschaulicht, daß S4 und S5 durch feste Verbindungen ersetzt werden, die ihren gestrichelten Schaltstellungen entsprechen. Hierbei wird der Eingang 45a mit einer festen Spannung belegt, die den Elektronenstrahl 19 helltastet, während über S1 ein Signal zugeführt wird, das den mittels der Teile 3 oder 33 lediglich in x-Richtung abgelenkten Elektronenstrahl zum Zwecke einer Kurvendarstellung zusätzlich in y-Richtung ablenkt. Auch dieses Signal kann extern zugeführt werden oder dem Speicher des Rechners 33 entnommen werden. Der Digital-Analog-Konverter 35 entfällt bei der zuletzt genannten Geräteversion.

14 Patentansprüche
 3 Figuren

0169453

<u>Patentansprüche</u>

1. Schaltungsanordnung zur Vermeidung von Einbrennerscheinungen auf dem Bildschirm (23) eines Sichtgerätes
(2, 3) mit einem intensitätsgesteuerten und über Ablenksysteme (21, 22) positionsgesteuerten Elektronenstrahl (19), insbesondere für ein Raster-Elektronenmikroskop, d a d u r c h g e k e n n z e i c h n e t ,
daß der Signaleingang (24) wenigstens eines Ablenksystems (21) mit einem Differenzierglied (47) beschaltet
ist, daß der Ausgang desselben mit dem ersten Eingang
eines Komparators (48) verbunden ist, dessen zweiter
Eingang (48a) mit einer Referenzspannung beaufschlagt
ist, daß der Ausgang des Komparators (48) an den Eingang
(49) eines nachtriggerbaren monostabilen Kippgliedes
(50) geschaltet ist und daß der Ausgang (41) des
letzteren an den Steuereingang (45) einer Kontrolleinheit (16) geführt ist, die die Intensitätssteuerung
des Elektronenstrahls (19) beeinflußt.

2. Schaltungsanordnung nach Anspruch 1, d a d u r c h
g e k e n n z e i c h n e t , daß die Signaleingänge
(24, 25) zweier den Elektronenstrahl (19) beeinflussender Ablenksysteme (21, 22) mit Differenziergliedern
(47, 53) und nachgeordneten Komparatoren (48, 54) beschaltet sind, deren zweite Eingänge (48a, 55) mit
jeweils einer Referenzspannung belegt sind und daß die
Ausgänge beider Komparatoren (48, 55) über ein ODER-
Glied (56) an den Eingang (49) des nachtriggerbaren monostabilen Kippgliedes (50) geschaltet sind.

3. Schaltungsanordnung nach einem der Ansprüche 1 oder
2, d a d u r c h g e k e n n z e i c h n e t , daß
der Ausgang (41) des Kippgliedes (50) an den ersten
Eingang einer Logikschaltung (42) gelegt ist, die
ausgangsseitig an den Steuereingang (45) der Kontrolleinheit (16) geschaltet ist, daß die Logikschaltung
(42) einen zweiten Eingang aufweist, der mit einem
ersten, die Ausrichtung des Elektronenstrahls (19) auf
die von diesem zu überstreichende Fläche (28) des
Bildschirms (23) anzeigenden Signal (LC, LC') belegt
ist, und daß die Logikschaltung (42) das Ausgangssignal
des Kippgliedes (50) in Abhängigkeit von dem Auftreten
dieses Signals auf den Steuereingang (45) der
Kontrolleinheit (16) überträgt.

4. Schaltungsanordnung nach Anspruch 3, d a d u r c h
g e k e n n z e i c h n e t , daß die Logikschaltung
(42) einen dritten Eingang aufweist, der in einem zweiten, die Ausrichtung des Elektronenstrahls (19) auf die
von diesem zu überstreichende Fläche (28) des Bildschirms (23) anzeigenden Signal (FC, FC') belegt ist,
und daß die Logikschaltung (42) das Ausgangssignal des
Kippgliedes (50) in Abhängigkeit von dem gemeinsamen
Auftreten des ersten und zweiten anzeigenden Signals
(LC, LC', FC, FC') auf den Steuereingang (45) der Kontrolleinheit (16) überträgt.

5. Schaltungsanordnung nach Anspruch 3 oder 4, d a -
d u r c h   g e k e n n z e i c h n e t , daß der
zweite Eingang der Logikschaltung (42) mit einem das
erste anzeigende Signal (LC) abgebenden Ausgang (43)
eines Rastergenerators (3) verbunden ist, der wenigstens
eine Ablenkspannung für die Ansteuerung wenigstens eines
Ablenksystems des Sichtgerätes erzeugt, und daß gegebenenfalls der dritte Eingang der Logikschaltung (42) mit
einem das zweite anzeigende Signal (FC) abgebenden
Ausgang (43a) des Rastergenerators (3) verbunden ist.

6. Schaltungsanordnung nach Anspruch 3 oder 4, d a -
d u r c h   g e k e n n z e i c h n e t , daß der

0169453

zweite Eingang der Logikschaltung (42) mit einem das erste anzeigende Signal (LC') abgebenden Ausgang (44) eines Rechners (33) verbunden ist, der wenigstens eine Ablenkspannung für die Ansteuerung wenigstens eines Ablenksystems des Sichtgerätes über einen Digital-Analog-Konverter (34) ausgibt, und daß gegebenenfalls der dritte Eingang der Logikschaltung (42) mit einem das zweite anzeigende Signal (FC') abgebenden Ausgang (44a) des Rechners (33) verbunden ist.

7. Schaltungsanordnung nach Anspruch 5 oder 6, d a - d u r c h g e k e n n z e i c h n e t , daß der zweite Eingang der Logikschaltung (42) über einen Umschalter (S3) mit den das erste anzeigende Signal (LC, LC') abgebenden Ausgängen (43, 44) des Rastergenerators (3) und des Rechners (33) verbunden ist und daß gegebenenfalls der dritte Eingang der Logikschaltung (42) über den Umschalter (S3) mit den das zweite anzeigende Signal (FC, FC') abgebenden Ausgängen (43a, 44a) des Rastergenerators (3) und des Rechners (33) verbunden ist.

8. Schaltungsanordnung nach einem der vorhergehenden An-sprüche, d a d u r c h g e k e n n z e i c h n e t , daß die Logikschaltung (42) als ein UND-Glied ausgebildet ist.

9. Schaltungsanordnung nach einem der vorhergehenden An-sprüche, d a d u r c h g e k e n n z e i c h n e t , daß die Kontrolleinheit (16) einen Signaleinang (45a) aufweist, an dem ein zur Intensitätssteuerung des Elektronenstrahls (19) dienendes Signal anliegt, daß der Ausgang der Kontrolleinheit (16) an den Intensitätssteuereingang (17) des Sichtgerätes geführt ist und daß ein Signalpfad zwischen dem Signaleingang (45a) und dem Ausgang der Kontrolleinheit (16) in Abhängigkeit vom Auftreten eines Kontrollsignals am Steuereingang (45) derselben wirksam geschaltet wird.

10. Schaltungsanordnung nach einem der vorhergehenden Ansprüche, d a d u r c h g e k e n n z e i c h n e t , daß das zur Intensitätssteuerung des Elektronenstrahls (19) dienende Signal am Detektorausgang (12) eines Raster-Elektronenmikroskops (1) abgegriffen wird.

11. Schaltungsanordnung nach einem der Ansprüche 1 bis 9, d a d u r c h g e k e n n z e i c h n e t , daß das zur Intensitätssteuerung des Elektronenstrahls (19) dienende Signal über einen Digital-Analog-Wandler (37) von einem, insbesondere die Position des Elektronenstrahls (19) steuernden, Rechner (33) ausgegeben wird.

12. Schaltungsanordnung nach einem der Ansprüche 1 bis 9, d a d u r c h g e k e n n z e i c h n e t , daß ein den Elektronenstrahl (19) in einer ersten Richtung über den Bildschirm (23) führendes Ablenksystem (21) mit einer Ablenkspannung beaufschlagt ist und daß ein zweites, in einer zweiten Richtung wirkendes Ablenksystem (22) mit einem Signal beaufschlagt wird, dessen Verlauf in Abhängigkeit von der jeweiligen Ablenkung des Elektronenstrahls (19) in der ersten Richtung auf dem Bildschirm (23) darzustellen ist, wobei der Intensitätssteuereingang (17) des Sichtgeräts mit einer konstanten Spannung belegt ist und die Verbindung zwischen dem Signaleingang (25) des zweiten Ablenksystems (22) und einem ihm nachgeschalteten Differenzierglied (53) unterbrochen ist.

13. Schaltungsanordnung nach Anspruch 12, d a d u r c h g e k e n n z e i c h n e t , daß das Signal, dessen Verlauf in Abhängigkeit von der jeweiligen Ablenkung des Elektronenstrahls in der ersten Richtung auf dem Bildschirm (23) darzustellen ist, am Ausgang (12) der Mikroskopsäule eines Raster-Elektronenmikroskops (1) abgegriffen wird.

14. Schaltungsanordnung nach Anspruch 12, d a d u r c h g e k e n n z e i c h n e t , daß das Signal, dessen Verlauf in Abhängigkeit von der jeweiligen Ablenkung des Elektronenstrahls in der ersten Richtung auf dem Bildschirm (23) darzustellen ist, über einen Digital-Analog-Konverter (37) von einem, insbesondere die Position des Elektronenstrahls steuernden, Rechner (33) ausgegeben wird.

FIG 1

1/2

0169453

FIG 2

FIG 3

Europäisches
Patentamt

# EUROPÄISCHER RECHERCHENBERICHT

| **EINSCHLÄGIGE DOKUMENTE** | | | EP 85108684.3 |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
| A | US - A - 4 198 661 (GATTEN)<br><br>* Abb. 1; Spalte 1, Zeilen 1-50; Spalte 2, Zeilen 25-52; Spalte 3; Zeile 19 - Spalte 4, Zeile 21 *<br><br>-- | 1 | H 01 J 37/24<br>H 04 N 3/20 |
| A | DE - A1 - 2 333 391 (NORDDEUTSCHE MENDE RUNDFUNK KG)<br><br>* Abb. Ansprüche *<br><br>-- | 1 | |
| A | US - A - 3 963 961 (RAY)<br><br>* Abb. 1; Spalte 4, Zeile 26 - Spalte 7, Zeile 43 *<br><br>---- | 1 | |
| | | | **RECHERCHIERTE SACHGEBIETE (Int. Cl 4)**<br><br>H 04 N   3/00<br>H 01 J 29/00<br>H 01 J 37/00<br>H 01 J   7/00<br>H 01 J 17/00<br>H 01 J 31/00 |

Der vorliegende Recherchenbericht wurde für alle Patentansprüche erstellt.

| Recherchenort | Abschlußdatum der Recherche | Prüfer |
|---|---|---|
| WIEN | 14-10-1985 | BRUNNER |